# EUROPEAN PATENT APPLICATION

(11) **EP 2 340 990 A1**
(43) Date of publication of application: **06.07.2011**
(21) Application number: 09275078.5
(22) Date of filing: 15.09.2009
(51) Int. Cl.: B63C 11/34, B63G 8/00, H05K 5/06

(54) **An electronic device**

(71) Applicant: BAE Systems PLC, London SW1Y 5AD (GB)
(72) Inventor: The designation of the inventor has not yet been filed
(74) Representative: McBrien, Matthew Nicholas

(57) **Abstract**

An electronic device comprising a support plate together with a first and a second cover is provided. One or more electrical components are mounted on the support plate.

The first cover is located on and connected to a first surface of the support plate. The first cover is configured and positioned to cover and thereby define a first sealed cavity over the, or each, respective component.

The second cover is located on and connected to a second, opposing, surface of the support plate. The second cover is configured to define a second sealed cavity and is positioned to, at least partially, overlap a region of the support plate covered by the first cover.

## Description

The present invention relates to an electronic device, in particular one suitable for use within an unmanned underwater vehicle.

Conventional unmanned underwater vehicles (UUV) use a, generally cylindrical, pressure vessel in which to mount all the electronic componentry required by such a UUV. One or each end plate of the vessel is then provided with a number of interfaces/sockets to which the internally mounted components can be connected to other, externally mounted, components. Primary disadvantages associated with this conventional configuration are that a significant number of expensive connectors must be used in the end plates to achieve the required level of reliability and that testing opportunities are restricted. Typically, the components can only be rigorously tested once all of the systems are in situ within the vessel. After installation of the components within the vessel, the components generally become quite inaccessible and replacement of any part may dislodge and/or cause damage to other components. Consequently, testing can be, at best, frustrating and time consuming but can be damaging and expensive.

It is desirable to provide a vehicle/device that is able to withstand a certain amount of pressure whilst inhibiting dust and/or water ingress yet permitting full testing of any internal components required by the vehicle/device. Furthermore, it is desirable to provide a compact, lightweight structure to facilitate/optimise the power required by the device.

According to a first aspect, the present invention provides an electronic device comprising:
a support plate, upon which is mounted an electrical component; a first cover, located on and connected to a first surface of the support plate, the first cover being configured and positioned to cover and thereby define a first sealed cavity over the, or each, respective component; and
a second cover, located on and connected to a second, opposing, surface of the support plate, the second cover being configured to define a second sealed cavity and positioned to, at least partially, overlap a region of the support plate covered by the first cover.

By providing an electronic device having a support plate upon which electrical components are mounted a very compact device can be achieved. Rigidity required is effected by provision of the first and second covers configured to, at least partially, overlap one another. The device as described, enables the components to be mounted upon the support plate and independently tested once in situ. Full accessibility can be gained to conduct a robust testing strategy rather than trusting that no dislodging has occurred when the covers are subsequently placed over the components. Advantages are found in cost savings, reduction in manufacturing complexity and reliability.

The support surface may comprise routing apertures formed therethrough within the overlap region of the covers to thereby enable passage of cables from the first sealed cavity to the second sealed cavity.

The, or each, cover may be a complex shape to enhance the structural rigidity thereof.

The device may comprise a third cover, located on and connected to the first surface of the support plate, the third cover may be configured to define a third sealed cavity and may be positioned to, at least partially, overlap a region of the support plate covered by the second cover.

The support plate may comprise a thermally conductive material upon which the, or each, component is mounted to effect cooling thereof. The support plate may additionally comprise a composite material, located outside a region upon which the, or each, component is mounted.

The electronic device may be a maritime electronic device, wherein each sealed cavity may comprise a water tight seal between a respective cover and the support plate to inhibit ingress of moisture into the cavity. It may comprise a skin, located over the, or each, cover and configured to define a "floodable" region of the device.

According to a second aspect the present invention provides a littoral unmanned underwater vehicle, comprising a device of the aforementioned type. The vehicle may be configured such that it can be launched by two users.

According to a third aspect, the present invention provides a maritime unmanned vehicle, configured to operate in a surface region of a body of water, comprising a device of the aforementioned type.

According to a fourth aspect, the present invention provides a ground based unmanned vehicle comprising a device of the aforementioned type, wherein each sealed cavity comprises a dust tight seal between a respective cover and the support plate to inhibit ingress of dust into the cavity.

According to a fifth aspect, the present invention provides a vehicle capable of flight, comprising a device of the aforementioned type. The vehicle may be a lighter than air device such as an airship or a balloon.

According to a sixth aspect, the present invention provides a method of manufacture of an electronic device comprising the steps of:
mounting components on a support plate;
wiring the components together;
testing the integrity of the components and the wiring in situ;
testing the operation and functionality of the components and the wiring in situ; and
installing a cover over the components forming a seal between the cover and the support plate.

The method may comprise a further step of vacuum and/or pressure testing the seal to determine the integrity thereof. The method may comprise the step of shrouding the device in a skin. The method may comprise the step of installing the device in a larger apparatus/vehicle.

By "sealed" we mean substantially water tight and/or dust tight.

By "vertical thruster" we mean a thruster which acts substantially perpendicular to the fore/aft direction and substantially perpendicular to a plane of the support plate.

The present invention is now described in more detail, with reference to the accompanying drawings, in which:
Figure 1 represents a schematic isometric view of the littoral unmanned underwater vehicle (UUV);
Figure 2 represents a schematic isometric view of an upper portion of the UUV with an outer skin removed;
Figure 3 represents a schematic isometric view of a lower portion of the UUV with an outer skin removed;
Figure 4 represents a schematic cross-sectional view of an interface between a pressure cover and a support plate;
Figure 5 represents a schematic isometric view corresponding to that of Figure 2 with pressure covers removed;
Figure 6 represents a schematic isometric view corresponding to that of Figure 3 with pressure covers removed;
Figure 7 represents a support surface/plate of the UUV of Figure 1 in isolation; and
Figure 8 represents a schematic side view of the UUV with an outer skin removed.

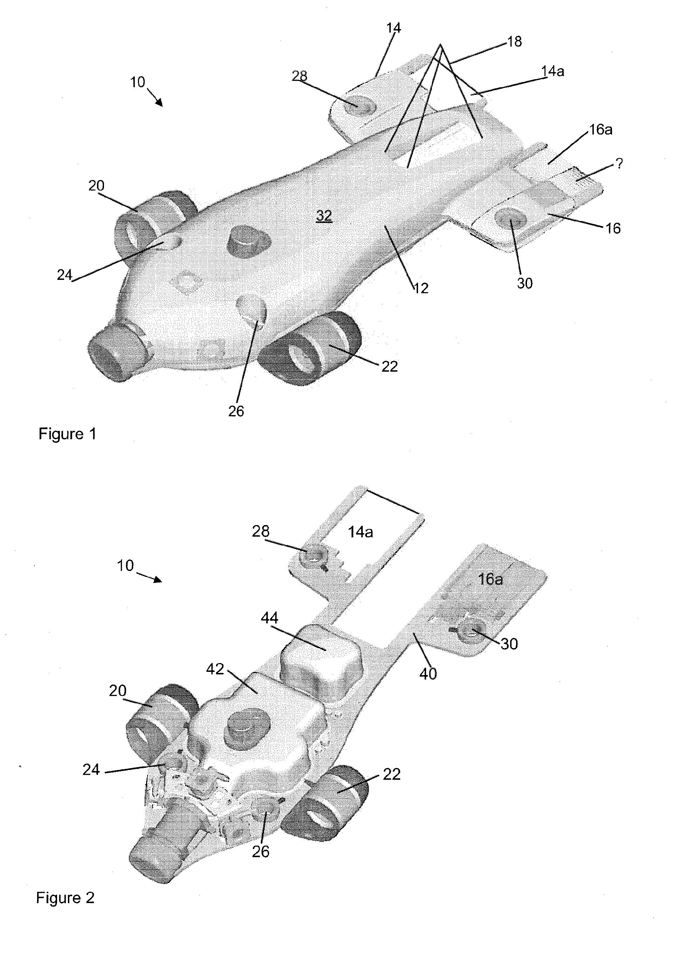

Figure 1 shows an isometric view of a littoral unmanned underwater vehicle (UUV) 10. The vehicle 10 comprises a main body portion 12 to which are connected lateral planes 14, 16 located towards the rear of the vehicle 10. Each lateral plane 14, 16 comprises a respective actuable control surface 14a, 16a. A fin 18, providing both stability and a housing for electronic components, is provided on an upper surface of the body portion 12 at a location substantially between the lateral planes 14, 16.

Fore/aft thrusters 20, 22 are attached to the body portion 12 in a forward location of the vehicle 10 as illustrated. Vertical thrusters 24, 26 are mounted through the body portion 12 substantially adjacent to each respective fore/aft thruster 20, 22. Further vertical thrusters 28, 30 are mounted through respective lateral planes 14, 16. The main body portion 12 comprises a shroud or outer skin 32 which not only provides a cosmetic finish to the vehicle but also serves to both reduce drag of the vehicle 10 during operation and perform a protective function for internal components of the vehicle. The outer skin 32 has been removed in the subsequent figures for the sake of clarity.

Figure 2 is an isometric view of an upper portion of the vehicle 10 with the outer skin 32 removed to reveal the structure and components located therewithin. In this figure, the primary structure of the vehicle 10 is revealed. The vehicle 10 comprises a primary support plate 40 which, in this embodiment, is formed from a single sheet of material extending across the entire plan form of the vehicle 10. The primary support plate 40 effectively provides an endoskeletal structure for the vehicle 10 upon which are mounted electronic sub-systems that provide the functionality of the vehicle 10.

The thrusters 20-30 and actuable control surfaces 14a, 16a described above are each mounted directly to the primary support plate 40 such that forces generated thereby are directly transmitted to the primary structure of the vehicle 10 to effect motion thereof.

The vehicle 10 serves as a carrier for a number of optical and acoustic sensors e.g. laser sensors, cameras and high resolution sonar sensors. These sensors are externally mounted at least in part.

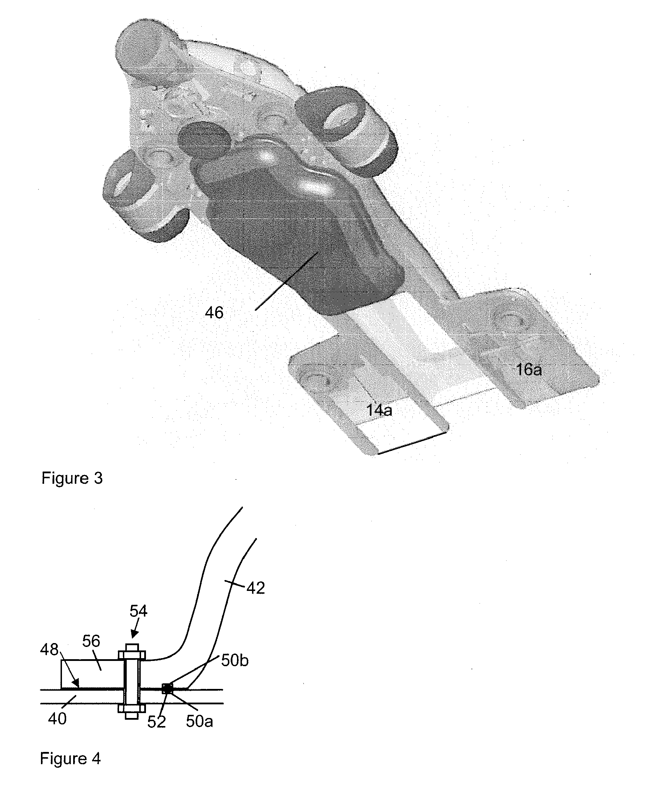

It is desirable to mount at least some of the sub-systems of the vehicle 10 within a substantially dry environment. To this end, covers 42, 44, 46 (see Figure 3) are sealably mounted directly onto the support plate 40. In this embodiment, the covers 42, 44, 46 are formed from a carbon fibre material, enabling the covers to be light weight and very resilient. In particular, the rigidity of the covers assists in preventing distortion of the support plate 40 when the vehicle 10 is subjected to a high pressure environment as may be found at an extreme range of the operating envelope of the vehicle 10. A UUV of this type is designed to operate to a depth of at least 100m (approximately 10 bar gauge). Each cover is, preferably, complex in shape which further contributes to the rigidity thereof. In this embodiment the covers 42, 44, 46 serve as pressure barriers, in alternative embodiments, pressure differences may not be experienced and the covers may serve as dust barriers or moisture barriers.

Figure 4 illustrates an interface between a cover 42 and the support plate 40. An interface surface 48 of the cover 42 is provided with a polished finish so that an effective seal between the cover 42 and the support plate 40 can be achieved. Furthermore, the support plate 40 and/or the surface 48 of the cover 42 can be provided with a groove 50a, 50b for receiving a resilient member 52 such as an o-ring seal. Consequently, a fastening member 54, such as a bolt can be used to secure/urge a flange 56 of the cover 42 onto the support plate 40, the resilient member 52 is compressed and the seal between the cover 42 and the support plate 40 is enhanced. A number of fastening members 54 are provided at spaced intervals around a perimeter of the flange 56 to further enhance the integrity of the seal.

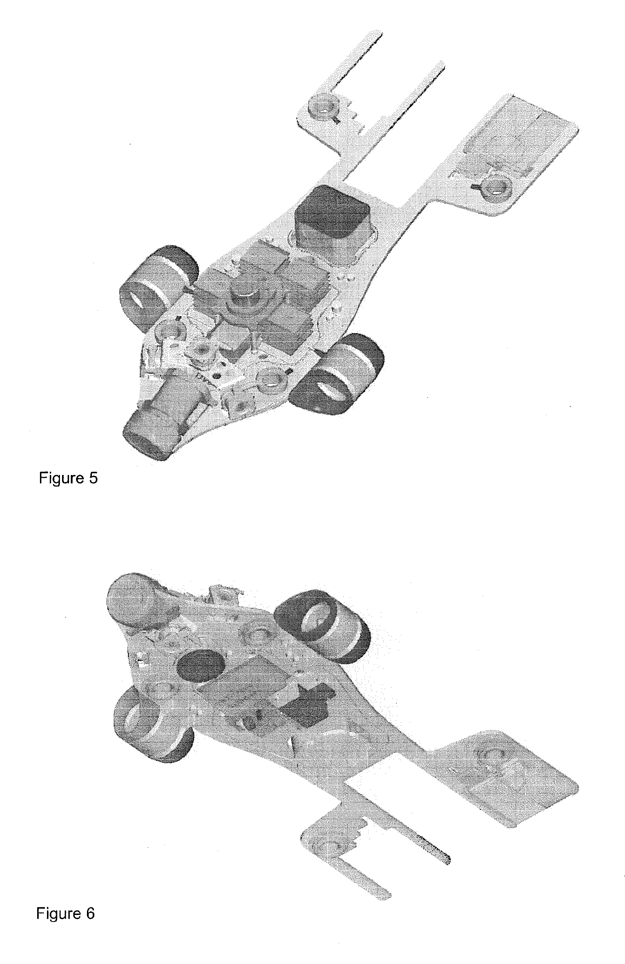

Figure 5 represents a similar view to that shown in Figure 2 having the covers 42, 44 removed such that electrical components of the electronic sub-systems mounted in the substantially dry environment underneath the covers are revealed. The electrical components may include stacks of PC104 format panel electronic circuits (PEC) and/or electronics relating to the external sensors. Figure 6 illustrates a corresponding view of the underside of the vehicle 10 with the cover 46 removed such that electrical components mounted in the sealed environment underneath the cover are revealed.

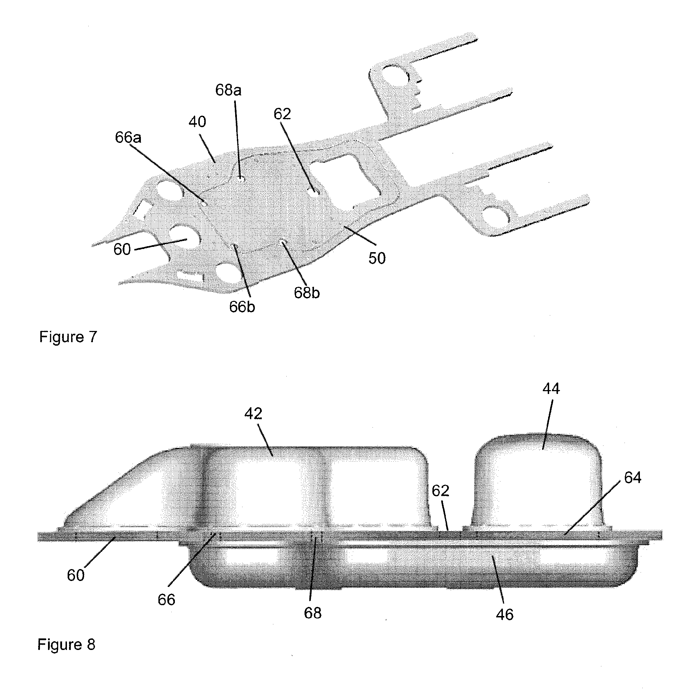

The support plate 40 is illustrated in isolation by Figure 7. As shown, an underside of the support plate 40 is represented together with a groove 50 for receiving an o-ring to generate a comprehensive seal with cover 46. A number of apertures are provided through the thickness of the plate 40 to enable passage of sub-system components or electrical wires to pass from one side of the plate 40 to an opposing side of the plate. In so doing, electrical components can be mounted on each side of the plate 40 to generate a compact configuration having each sub-system in direct contact with the support plate 40. In this example, the support plate 40 is provided by a 12 mm aluminium sheet, cut to shape as illustrated. Aluminium is used in this example as it provides a relatively light weight, yet strong, structure that is also thermally conductive. As the vehicle 10 is flooded in normal operation, the plate 40 is in constant thermal contact with the ambient water. Consequently, heat generated by each of the electrical components is drawn directly from each respective component, conveyed to a cooler region of the plate and thereby dissipated by virtue of the thermal gradient represented across the aluminium plate.

As mentioned above, in this embodiment, the plate 40 is formed from a single sheet of material extending across the entire plan form of the vehicle 10 as illustrated in Figure 7. However, if it is necessary to further reduce the weight of the vehicle 10, the plate 40 could be formed from two parts. A first, thermally conductive, part upon which the heat generating electrical components are mounted could be connected to a second peripheral part. The second part, may have poorer thermal conduction properties than the material of the first part, but is lighter in weight whilst retaining the strength required. For example, the second part may be formed from composite material and may extend to the longitudinal and lateral spatial extremes of the vehicle 10.

Figure 8 represents a side view of the support plate 40 together with the covers 42, 44, 46 in situ. The overlapping configuration of the covers in combination with their complex shape further enhances the rigidity of the vehicle's structure. The apertures through support plate 40 are represented by dashed lines and are discussed in more detail below. Apertures 60, 62, 64 are mounted centrally (in a lateral sense) and are configured to receive components directly. Apertures 60 and 62 are each enclosed on one side by covers 42 and 46 respectively but contain sealing means around a peripheral portion of each respective aperture so that a seal, preferably a water tight seal, is achieved between the support plate 40 and a respective component. This configuration enables a first portion of each respective component to be in direct contact with the ambient atmosphere (e.g. the sea) whilst a second portion of each respective component is mounted in the substantially dry enclosure defined by the covers 42, 44, 46 and support plate 40 in combination.

The remaining apertures 66a, 66b, 68a, 68b, are formed in support plate 40 in regions having both surfaces of the support plate 40 in a substantially dry environment. In other words, in a region experiencing overlap of the covers 42, 46 on an upper surface and a lower surface of the support plate 40 respectively. These apertures 66, 68 represent paths through the plate 40 from one dry enclosure to another. Consequently, dry wiring between components located on opposing sides of the support plate 40 can be used. Dry wiring is cheaper, simpler and more robust/reliable than wiring that must be designed and tested to pass through water.

External sensors may be mounted in such a way that they protrude through a cover. For example a communications transducer or a speed sensor benefits from direct contact with the surrounding environment/medium. Such a device is illustrated protruding through cover 42 in Figure 2 and further protrudes through the external skin 32 in Figure 1.

The configuration of the UUV of the present embodiment enables components and sub-systems to be optimally located on the vehicle rather than being forced into a confined and restrictive geometry defined by a conventional pressure vessel, such as a cylinder.

In devices comprising a conventional pressure vessel, components and sub-systems are wired together and inserted into the cylindrical vessel (generally open at only one end). The components and sub-systems are then quite inaccessible and whilst testing of these systems is subsequently undertaken, any faults are not only difficult to detect but may be exacerbated during insertion and subsequent removal from the pressure vessel. By using the configuration of the present invention each component of a sub-system can be separately mounted onto the support plate 40. The support plate 40 may, in turn, be mounted on a rotatably mounted test rig to further facilitate and enhance access to the components. The components can be tested in situ, in isolation and then, subsequently, be dry wired to one another. The components and their connections can be readily tested again in isolation or in combination with one another prior to installation of the covers 42, 44, 46. The components are tested again with the covers 42, 44, 46 in place to ensure that no wiring or components have been inadvertently dislodged. The covers are vacuum tested to check the integrity of the seal formed between each component and the support plate 40. Finally, the shroud/outer skin 32 is introduced to complete assembly of the vehicle 10.

Alternative applications of the present invention may include use in ground based vehicles configured to be operated in an extreme environment e.g. dust laden atmospheres such as a desert. In this example, the integrity of the seal between each cover and the support plate are sufficient/adequate to inhibit dust ingress which, in turn, would prove detrimental to the functioning of electronic components of any sub-assemblies mounted within the vehicle.

Furthermore, as the present invention represents a lightweight yet robust and rigid structure, it is particularly suited to use in vehicles capable of flight also referred to here in as "airborne vehicles" especially lighter than air devices such as an airship or a weather balloon. The term "airborne vehicles" is intended to include tethered and non-tethered vehicles having or lacking propulsion.

## Claims

1. An electronic device comprising:
a support plate, upon which is mounted an electrical component;
a first cover, located on and connected to a first surface of the support plate, the first cover being configured and positioned to cover and thereby define a first sealed cavity over the, or each, respective component; and
a second cover, located on and connected to a second, opposing, surface of the support plate, the second cover being configured to define a second sealed cavity and positioned to, at least partially, overlap a region of the support plate covered by the first cover.

2. A device according to Claim 1, wherein the support surface comprises routing apertures formed therethrough within the overlap region of the covers to thereby enable passage of cables from the first sealed cavity to the second sealed cavity.

3. A device according to Claim 1 or Claim 2, wherein the, or each, cover is a complex shape.

4. A device according to any preceding claim, comprising a third cover, located on and connected to the first surface of the support plate, the third cover being configured to define a third sealed cavity and positioned to, at least partially, overlap a region of the support plate covered by the second cover.

5. A device according to any preceding claim, wherein the support plate comprises a thermally conductive material upon which the, or each, component is mounted to effect cooling thereof.

6. A device according to Claim 5, wherein the support plate additionally comprises a composite material located outside a region upon which the, or each, component is mounted.

7. A maritime electronic device according to any preceding claim, wherein each sealed cavity comprises a water tight seal between a respective cover and the support plate to inhibit ingress of moisture into the cavity.

8. A maritime electronic device according to Claim 7, comprising a skin, located over the, or each, cover and configured to define a "floodable" region of the device.

9. A maritime unmanned vehicle, configure to operate in a surface region of a body of water, comprising a device according to any of Claims 1 to 8.

10. A ground based unmanned vehicle comprising a device according to any of Claims 1 to 6, wherein each sealed cavity comprises a dust tight seal between a respective cover and the support plate to inhibit ingress of dust into the cavity.

11. A vehicle capable of flight, comprising a device according to any of Claims 1 to 6.

12. A method of manufacture of an electronic device comprising the steps of:
mounting components on a support plate;
wiring the components together;
testing the integrity of the components and the wiring in situ;
testing the operation and functionality of the components and the wiring in situ; and
installing a cover over the components forming a seal between the cover and the support plate.

13. A method according to Claim 12, comprising the further step of vacuum and/or pressure testing the seal to determine the integrity thereof.

14. A method according to Claim 13, comprising the step of shrouding the device in a skin.

15. A method according to any of Claims 12 to 14, comprising the step of installing the device in a larger apparatus/vehicle.
